(19) Europäisches Patentamt
European Patent Office
Office européen des brevets

(11) EP 3 608 778 A1

(12) EUROPÄISCHE PATENTANMELDUNG

(43) Veröffentlichungstag:
12.02.2020 Patentblatt 2020/07

(51) Int Cl.:
G06F 9/4401 (2018.01)          G06F 9/445 (2018.01)
H03M 7/30 (2006.01)

(21) Anmeldenummer: 19189983.0

(22) Anmeldetag: 05.08.2019

(84) Benannte Vertragsstaaten:
AL AT BE BG CH CY CZ DE DK EE ES FI FR GB
GR HR HU IE IS IT LI LT LU LV MC MK MT NL NO
PL PT RO RS SE SI SK SM TR
Benannte Erstreckungsstaaten:
BA ME
Benannte Validierungsstaaten:
KH MA MD TN

(30) Priorität: 07.08.2018 DE 102018006226

(71) Anmelder: Diehl Defence GmbH & Co. KG
88662 ÜBERLINGEN (DE)

(72) Erfinder: Koltes, Andreas
88662 Überlingen (DE)

(74) Vertreter: Diehl Patentabteilung
c/o Diehl Stiftung & Co. KG
Stephanstraße 49
90478 Nürnberg (DE)

(54) VERFAHREN ZUM BOOTEN EINES DATENVERARBEITUNGSSYSTEMS

(57) Die Erfindung betrifft ein Verfahren zum Booten eines Datenverarbeitungssystems (10).

Um ein besonders schnelles Booten zu erreichen, wird vorgeschlagen, dass ein Boot Loader (18) aus einem nichtflüchtigen Datenspeicher (14) zu einer CPU (12) übertragen wird, dieser das Datenverarbeitungssystem (10) bootet und veranlasst, dass komprimierte Programmdaten (22) aus dem nichtflüchtigen Datenspeicher (14) durch die CPU (12) entkomprimiert werden und sie entkomprimiert in einen flüchtigen Datenspeicher (16) abgelegt werden, sie von dort zu einem Programmstart aufgerufen und mit ihnen ein Programm ausgeführt wird.

FIG 3

EP 3 608 778 A1

**Beschreibung**

Die Erfindung betrifft ein Verfahren zum Booten eines Datenverarbeitungssystems.

Beim Start eines elektronischen Datenverarbeitungssystems wird dieses nach der Herstellung der Spannungsversorgung gebootet. Hierfür werden Programmdaten von einem nichtflüchtigen Datenspeicher in einen flüchtigen Datenspeicher des elektronischen Systems geladen und diese werden von der CPU bearbeitet, bis das Programm soweit abgearbeitet ist, dass die Arbeitsbereitschaft des elektronischen Systems hergestellt ist. Das elektronische System ist nun bereit, weitere Aufgaben entsprechend des Programms zu übernehmen und abzuarbeiten. Dieser Vorgang der Herstellung der Arbeitsbereitschaft kann etwas Zeit in Anspruch nehmen.

Es ist die Aufgabe der vorliegenden Erfindung, ein Verfahren zum schnellen Booten eines Datenverarbeitungssystems bereitzustellen.

Diese Aufgabe wird durch ein Verfahren der eingangs genannten Art gelöst, bei dem komprimierte Programmdaten aus einem nichtflüchtigen Datenspeicher durch die CPU entkomprimiert werden und sie entkomprimiert in einen flüchtigen Datenspeicher abgelegt werden, sie von dort zu einem Programmstart aufgerufen und mit ihnen der Programmstart ausgeführt wird.

Die Erfindung geht von der Überlegung aus, dass es bei der Verwendung eines Verteidigungssystems vorkommen kann, dass dieses sehr schnell einsatzbereit sein muss, wenn eine Bedrohung durch ein angreifendes System erkannt wurde. Unter Umständen bleibt nur bei einer schnellen Einsatzbereitschaft des Verteidigungssystems genügend Zeit, um die Bedrohung erfolgreich bekämpfen zu können. Beispielsweise erfordern Luftabwehrsysteme die Herstellung der vollen Wirkfähigkeit in sehr kurzer Zeit, um auf auftretende Bedrohungen, wie anfliegende Flugkörper, mit sehr kurzer Latenzzeit durch Abschuss eines oder mehrerer Verteidigungsflugkörper reagieren zu können.

Moderne Lenkflugkörper verfügen über zunehmend komplexe und leistungsfähige elektronische Rechnereinheiten, die in das Waffensystem eingebettet sind und in kurzer Zeit arbeitsbereit gemacht müssen. Während des Starts einer solchen Rechnereinheit ist es erforderlich, mit zunehmender Systemkomplexität zunehmend große Datenmengen aus einem langsamen, nichtflüchtigen Datenspeichern, wie einem Flash Chip, in einen schnellen aber flüchtigen Arbeitsspeicher, wie einen DDR RAM Chip, zu transferieren. Da die Transfergeschwindigkeiten von nichtflüchtigen Datenspeichern nicht in der gleichen Geschwindigkeit wachsen, wie die zu transferierenden Datenvolumen, kann ein Datentransfer vom nichtflüchtigen Datenspeicher zur CPU beziehungsweise zum flüchtigen Datenspeicher ein zeitliches Nadelöhr beim Booten und/oder nachfolgenden weiteren Startschritten der Rechnereinheit bilden. Um die Bootgeschwindigkeit zu erhöhen und damit die Herstellung der Einsatzbereitschaft der Rechnereinheit zügiger zu erreichen, sind verbesserte Startkonzepte erforderlich, um die schnellen Startzeiten früherer Systeme auch bei hoher Systemkomplexität zu erzielen oder sogar übertreffen zu können.

Dieses Problem wird von der Erfindung dadurch gelöst, dass die Programmdaten in komprimierter Form im nichtflüchtigen Datenspeicher abgelegt sind und hierdurch eine geringere Datenmenge bilden, die zum flüchtigen Datenspeicher transferiert werden muss. Das Entkomprimieren der Programmdaten als hierbei zusätzlicher Schritt benötigt weniger zusätzliche Zeit, als der Transfer komprimierter Daten gegenüber einem Transfer unkomprimierter Daten einspart. Ein Starten des Datenverarbeitungssystems, das das Booten sein oder noch weitere Schritte beinhalten kann, kann beschleunigt werden, und das elektronische System ist schneller einsatzbereit.

Zum Booten des Datenverarbeitungssystems verwendete Programmdaten liegen insofern in komprimierter Form im nichtflüchtigen Datenspeicher, der auch in stromlosem Zustand diese Daten behält. Bei Herstellung der Spannungsversorgung der CPU und des Datenspeichers können diese Daten zur CPU übertragen werden und von der CPU, ggf. in Kombination mit dem flüchtigen Datenspeicher, entkomprimiert und in entkomprimiertem Zustand in den flüchtigen Datenspeicher übertragen werden. In diesem liegt dann das Programm entpackt, also entkomprimiert vor und kann zum Booten des Datenverarbeitungssystems abgearbeitet werden. Das heißt, dass die zum Booten benötigten Daten zunächst entkomprimiert werden und dann mit ihnen weitere Schritte des Startens des Datenverarbeitungssystems ausgeführt werden können.

Das Booten des Datenverarbeitungssystems kann das Laden eines Betriebssystems des Datenverarbeitungssystems beinhalten oder sein. Das Betriebssystem kann ein oder mehrere Programme enthalten, die die Systemressourcen des Datenverarbeitungssystems verwalten. Eine solche Ressource kann ein FPGA (Field Programmable Gate Device) sein, dessen Konfigurationsdaten Programmdaten des Bootvorgangs sein können. Das Datenverarbeitungssystem kann ein hybrides System mit einer CPU und einem FPGA sein, in das Daten für logische Schaltungen geladen werden, mit denen das FPGA konfiguriert wird. Das Booten kann insofern das Laden und Ausführen von Firmware zur Herstellung der Arbeitsfähigkeit des FPGA, als auch von weiterer Programmsoftware zur Herstellung der Arbeitsfähigkeit weiterer Komponenten beinhalten. Das Laden kann das Entkomprimieren beinhalten.

Zum Booten des Datenverarbeitungssystems kann ein Boot Loader vom nichtflüchtigen Datenspeicher zur CPU und/oder den flüchtigen Datenspeicher übertragen werden, der das Booten des Datenverarbeitungssystems initiiert. Der Boot Loader ist zweckmäßigerweise unkomprimiert im nichtflüchtigen Datenspeicher hinterlegt. Der Boot Loader kann das Entkomprimieren der Programmdaten initiieren.

Das Booten des Datenverarbeitungssystems kann beinhalten, dass zur Herstellung der regulären Arbeitsbereitschaft des Datenverarbeitungssystems ein Programm abgearbeitet werden muss, ohne dass das Datenverarbeitungssystem nicht einsatzbereit ist. Die Einsatzbereitschaft kann die reguläre Einsatzbereitschaft sein, die das Datenverarbeitungssystem zur Abarbeitung seiner grundlegenden Aufgaben aufweisen muss. Ein Programmstart kann das Starten des Ausführens von ausführbarer Software, Firmware und/oder Konfigurationssoftware zur Konfigurierung eines FPGA sein.

Es ist insofern in einer Ausführungsform der Erfindung zweckmäßig, dass die Programmdaten FPGA-Firmware sind, mit denen ein FPGA konfiguriert wird. Der Boot Loader kann das Konfigurieren des FPGA mit den Daten aus dem flüchtigen Datenspeicher initiieren.

Die CPU und das FPGA bilden vorteilhafterweise ein eingebettetes System (embedded system) des Datenverarbeitungssystems, bei dem beide Einheiten insbesondere auf einer gemeinsamen Platine angeordnet sind. Das eingebettete System ist zweckmäßigerweise in einen technischen Kontext eingebunden, beispielsweise in ein Flugkörpersystem zum Starten eines oder mehrerer Flugkörper.

In einer weiteren vorteilhaften Ausgestaltung der Erfindung sind die komprimierten Programmdaten auf Maschinenwortebene komprimiert, das Kompressionsverfahren verwendet also eine Kodierung auf Maschinenwortebene. Entsprechend ist es vorteilhaft, wenn die Entkomprimierung auf Maschinenwortebene erfolgt.

Die komprimierten Daten können als ein einziger zusammenhängender Datenblock vorliegen und zu einem einzigen zusammenhängenden Datenblock entkomprimiert werden. Zweckmäßigerweise liegen die Programmdaten sowohl in komprimierter Form im nichtflüchtigen Datenspeicher als auch in entkomprimierter Form im flüchtigen Datenspeicher ausschließlich als Wörter in Multibytegröße gleicher Größe vor, also ganzzahlige Bytes, insbesondere ausschließlich als 4-Byte Wörter. Das heißt, dass der Dekompressor einen Datenblock aus nur 32-Bit ganzzahligen Werten empfängt und einen entkomprimierten Datenblock aus nur 32-Bit ganzzahligen Werten ausgibt.

Eine besonders effiziente Komprimierung kann erreicht werden, wenn die Programmdaten mittels eines ersten Komprimierungsverfahrens, zweckmäßigerweise aus der LZ-Familie (Lempel-Ziv-Kompression), komprimiert sind und mit den entsprechenden Verfahren entkomprimiert werden, beispielsweise mittels LZ77. Durch ein Kompressionsverfahren der LZ-Familie kann jedes Wort der unkomprimierten Daten in ein Token umgewandelt werden, sodass die komprimierten Daten die unkomprimierten Daten durch eine Sequenz von Token beschreiben. Weiter vorteilhaft ist eine anschließende Huffman-Kompression. Die Entkomprimierung erfolgt zweckmäßigerweise mit den gleichen Verfahren in umgekehrter Reihenfolge.

Ein Token kann ein Wort aus den unkomprimierten Daten zeichengetreu wiedergeben oder in einer vorgegebenen Weise auf ein bereits entkomprimiertes Wort referenzieren, das ganz oder teilweise gleich ist zu dem Wort, das durch den Token kodiert wird. Bei der Entkomprimierung kann der Dekompressor aus dem im Token angegebenen Offset, also dem Abstand vom referenzierten Wort zu dem Wort, das er selber repräsentiert, angegeben in Wortlängen, Daten seines Worts aus den gleichen Daten des referenzierten Worts extrahieren, das bereits entkomprimiert wurde.

Die Huffman-Kompression kann einen sogenannten Huffmanbaum verwenden, in dem jedem Token ein oder mehrere Zeichen zugeordnet sind, wobei die Länge einer solchen Zeichenkette bei oft verwendeten Token kürzer ist als bei weniger oft verwendeten Token.

Eine weitere vorteilhafte Ausgestaltung der Erfindung sieht vor, dass die Programmdaten im nichtflüchtigen Datenspeicher entropiekodiert sind und sämtliche zum Starten des Datenverarbeitungssystems verwendeten Daten mithilfe von maximal drei Huffmanbäumen entkomprimiert werden. Diese Huffmanbäume werden zweckmäßigerweise für die Entkomprimierung des gesamten Programmcodes verwendet, der zum Booten beziehungsweise Starten des Datenverarbeitungssystems notwendig ist. Hierdurch kann neben der verlustfreien Kompression eine effiziente Entkomprimierung erfolgen.

Die Huffmanbäume können im komprimierten Datenblock zwischen dem Header und dem komprimierten Datenteil angeordnet sein. Zweckmäßigerweise ist die maximale Länge der Huffmansymbole im Hauptbaum auf 12 Bits und in den beiden Offsetbäumen auf 10 Bits begrenzt.

Jedem Huffmanbaum kann ein Alphabet zugeordnet sein. Ein Hauptalphabet kann den Typ des jeweiligen Tokens beschreiben. Ein erstes Offset-Alphabet kann den Offset von Einzelwortwiederholungen beschreiben und ein zweites Offset-Alphabet kann den Offset von Mehrwortwiederholungen beschreiben.

Vorteilhafterweise wird einer der Huffmanbäume zur Bestimmung einer Tokenart und mindestens ein weiterer Huffmanbaum zur Bestimmung der Rückwärtsoffsets zu gleichartigen Daten verwendet, wie Ein- oder Mehrwortwiederholungen. Token können in den komprimierten Daten mit einem oder zwei Symbolen jeweils eines Huffmanbaums beschrieben werden, gegebenenfalls gefolgt von einer vorbestimmten Anzahl von weiteren Bits mit weiteren Informationen.

Zur Dekodierung beziehungsweise Entkomprimierung der Daten durch Huffmanbäume werden Lookup-Tabellen verwendet. Diese sind zweckmäßigerweise so beschaffen, dass sie vollständig in den L1-Cache der CPU des Datenverarbeitungssystems passen, die den Dekomprimierungsalgorithmus ausführt. Um dies zu erreichen ist es zweckmäßig, wenn die Entkomprimierung maximal drei einstufige Lookup-Tabellen verwendet, die jeweils aus einem Feld aus maximal 4096 16-Bit-Werten bestehen.

Hierbei sind die Lookup-Tabellen zweckmäßigerweise an die Huffmannbäume angepasst. Zwei der Lookup-Tabellen können aus 1024 16-Bit-Werten bestehen. Eine besonders zügige Entkomprimierung kann erreicht werden, wenn die komprimierten Programmdaten einen vollständigen Programmdatensatz bilden. Dieser wird zweckmäßigerweise zur Entkomprimierung ausschließlich durch den L1-Cache der CPU geführt. Rückgriffe auf bereits entkomprimierte Daten können zur weiteren Entkomprimierung der Programmdaten zumindest überwiegend auf den L2-Cache der CPU erfolgen. Auf diese Weise muss kein RAM-Zugriff zum Lesen von bereits entkomprimierten Daten erfolgen. Die Rückgrifflängen sind zweckmäßigerweise so gewählt, insbesondere so kurz, dass die Daten, auf die zurückgegriffen wird, zumindest überwiegend in den L2-Cache passen.

Wie beschrieben, können zur Entkomprimierung Token verwendet werden, die als Dateninhalt vorne ein Symbol für die Tokenart und dahinter optional ein Symbol für einen Offset und/oder Extrabit enthalten, wobei diese zweckmäßigerweise auf maximal 32 Bit begrenzt sind. Die Anzahl der Extrabit kann durch die Tokenart festgelegt sein.

Als Tokenart sind eine oder mehrere beliebige der folgenden Kategorien sinnvoll:

- Zeichengetreue Wiedergabe, auch Verbatim oder Literal genannt
- Einwortwiederholungen, auch Short genannt
- Mehrwortwiederholungen, auch Long genannt
- Kette gleicher Wörter, auch Run genannt

Jede Tokenkategorie kann mehrere Tokentypen enthalten. Die Kategorie der Token der zeichengetreuen Wiedergabe kann einen oder mehrere beliebige der folgenden Tokentypen enthalten:

- Nullwort aus nur Nullen
- Eine zeichengetreue Wiedergabe eines Worts
- Vorderer Nullenteil
- Hinterer Nullenteil
- Vorderer Einsenteil
- Hinterer Einsenteil

In anderen Worten, es kann zur Entkomprimierung eine Literal-Tokenkategorie mit Token verwendet werden, die eine Zeichenfolge aus vorangestellten oder nachgestellten Nullen oder Einsen separat zum Literal-Teil, also zeichengetreuen Teil, komprimiert.

Die Kategorie der Einwortwiederholungen kann einen oder mehrere beliebige der folgenden Tokentypen enthalten:

- Gleiches Wort
- Gleiches Wort mit 1 Bit Unterschied
- Gleiches Wort mit 2 Bit Unterschied
- Sprungbefehl

In anderen Worten, es kann zur Entkomprimierung eine Tokenkategorie verwendet werden, deren Token jeweils auf ein früheres, also bereits entkomprimiertes Wort verweisen und Änderungen von einem oder zwei - dann zweckmäßigerweise hintereinander liegenden - Bits zulassen.

Die Kategorie der Mehrwortwiederholungen kann einen oder beide der folgenden Tokentypen enthalten:

- Anzahl gleicher Wörter tokenartkodiert
- Anzahl gleicher Wörter extrabitkodiert

In anderen Worten, es kann zur Entkomprimierung eine Tokenkategorie verwendet wird, deren Token jeweils mehrere unmittelbar hintereinander liegende identische Wörter bezeichnen.

Die Kategorie der Kette gleicher Wörter kann einen oder beide der folgenden Tokentypen enthalten:

- Anzahl Wiederholungen tokenartkodiert
- Anzahl Wiederholungen extrabitkodiert

In anderen Worten, es kann zur Entkomprimierung eine Tokenkategorie verwendet werden, deren Token jeweils auf eine Reihe von unmittelbar vorabliegenden identischen Wörtern verweisen.

Insbesondere bei einer Entkomprimierung von Programmdaten zur FPGA-Konfiguration ist es effektiv, wenn zur Entkomprimierung verschiedener Tokentypen die Reihenfolge der Tokentypen so abgeprüft wird, dass zunächst Tokentypen der zeichengetreuen Tokenkategorie, dann Tokentypen der Tokenkategorie der Einwortwiederholungen und dann weitere Tokentypen der zeichengetreuen Tokenkategorie abgeprüft werden.

Wie beschrieben, ist es sinnvoll, wenn die Programmdaten einen vollständigen Programmdatensatz bilden, der als ein einziger Datenblock komprimiert ist. In dessen Modellteil können sämtliche Dekodierbäume enthalten sein, die zur Entkomprimierung verwendet werden. Die Programmdaten bilden zweckmäßigerweise ein oder mehrere zusammenhängende komplette Programme, das beziehungsweise die also lauffähig sind.

Weiter ist es vorteilhaft, wenn die komprimierten Programmdaten in zwei ineinander verschachtelten Sequenzen aus jeweils Wörtern gleicher Länge vorliegen. Hierbei kann die erste Wortsequenz aus komprimierten Programmdaten und die zweite Wortsequenz aus unkomprimierten Programmdaten bestehen. Zweckmäßigerweise haben alle Wörter beider Sequenzen die gleiche Länge.

Bei Vorhandensein mehrerer Rechenkerne in der CPU kann eine zügige Entkomprimierung erreicht werden, wenn die komprimierten Programmdaten in mehreren Datenblöcken vorliegen, wobei die Anzahl der Datenblöcke der Anzahl der Rechenkerne der CPU gleicht. Die Datenblöcke können parallel den Rechenkernen zur Entkomprimierung zugeführt werden, sodass durch die parallele Verarbeitung die Entkomprimierung beschleunigt wird. Die Datenblöcke bilden zweckmäßigerweise jeweils einen zusammenhängenden entkomprimierten Programmdatenteil. Um eine gleichmäßige Auslastung der einzelnen Rechenkerne zu erreichen, ist es vorteilhaft, wenn sich die Anzahlen der Token in den Datenblöcken um maximal 20 % voneinander unterscheiden.

Die Erfindung ist außerdem gerichtet auf ein Flugabwehrsystem mit einem Flugkörper und einem Datenverarbeitungssystem zum Steuern eines Betriebs des Flugkörpers, wobei das Datenverarbeitungssystem eine CPU, einen flüchtigen Datenspeicher und einen nichtflüchtigen Datenspeicher aufweist und Software enthält, die bei ihrer Ausführung bewirkt, dass komprimierte Programmdaten aus dem nichtflüchtigen Datenspeicher durch die CPU entkomprimiert werden und sie entkomprimiert in den flüchtigen Datenspeicher abgelegt werden, sie von dort zu einem Programmstart aufgerufen und mit ihnen das Programm ausgeführt wird.

Der Flugkörper kann das Datenverarbeitungssystem enthalten, das dessen Flug steuert, und/oder ein Startgerät, aus dem der Flugkörper startet, kann das Datenverarbeitungssystem enthalten, wobei dieses Datenverarbeitungssystem dann den Start steuert.

Allgemein ist die Erfindung auch vorteilhaft für ein Datenverarbeitungssystem an sich, das eine CPU, einen flüchtigen Datenspeicher und einen nichtflüchtigen Datenspeicher aufweist und die beschriebene Software enthält. Das Datenverarbeitungssystem ist zweckmäßigerweise ein sogenanntes Embedded System mit einer CPU und einem FPGA, zweckmäßigerweise auf einer gemeinsamen Platine. Der flüchtige Datenspeicher kann so ausgeführt sein, dass er bei Stromlosschaltung seine Daten zumindest überwiegend verliert, wohingegen der nichtflüchtige Datenspeicher seine Daten bei Stromlosschaltung behält.

Die bisher gegebene Beschreibung vorteilhafter Ausgestaltungen der Erfindung enthält zahlreiche Merkmale, die teilweise in einigen abhängigen Ansprüchen zu mehreren zusammengefasst wiedergegeben sind. Die Merkmale können jedoch zweckmäßigerweise auch einzeln betrachtet und zu sinnvollen weiteren Kombinationen zusammengefasst werden, insbesondere bei Rückbezügen von Ansprüchen, sodass ein einzelnes Merkmal eines abhängigen Anspruchs mit einem einzelnen, mehreren oder allen Merkmalen eines anderen abhängigen Anspruchs kombinierbar ist. Außerdem sind diese Merkmale jeweils einzeln und in beliebiger geeigneter Kombination sowohl mit dem erfindungsgemäßen Verfahren als auch mit dem erfindungsgemäßen Datenverarbeitungssystem insbesondere gemäß den unabhängigen Ansprüchen kombinierbar. So sind Verfahrensmerkmale auch als Eigenschaften der entsprechenden Vorrichtungseinheit gegenständlich formuliert zu sehen und funktionale Vorrichtungsmerkmale auch als entsprechende Verfahrensmerkmale.

Die oben beschriebenen Eigenschaften, Merkmale und Vorteile dieser Erfindung sowie die Art und Weise, wie diese erreicht werden, werden klarer und deutlicher verständlich in Zusammenhang mit der folgenden Beschreibung der Ausführungsbeispiele, die im Zusammenhang mit den Zeichnungen näher erläutert werden. Die Ausführungsbeispiele dienen der Erläuterung der Erfindung und beschränken die Erfindung nicht auf die darin angegebene Kombination von Merkmalen, auch nicht in Bezug auf funktionale Merkmale. Außerdem können dazu geeignete Merkmale eines jeden Ausführungsbeispiels auch explizit isoliert betrachtet, aus einem Ausführungsbeispiel entfernt, in ein anderes Ausführungsbeispiel zu dessen Ergänzung eingebracht und/oder mit einem beliebigen der Ansprüche kombiniert werden.

Es zeigen:

FIG 1     ein Flugabwehrsystem mit mehreren Flugkörpern, die jeweils in einem Kanister 6 gelagert sind, und einem Datenverarbeitungssystem,

FIG 2     ein Ablaufschema zum Booten des Datenverarbeitungssystems,

FIG 3     eine schematische Übersicht über einen Komprimierungs- und Entkomprimierungsvorgang von Programmdaten und

FIG 4     ein Ablaufdiagramm zur Entkomprimierung von Hauptsymbolen von Token.

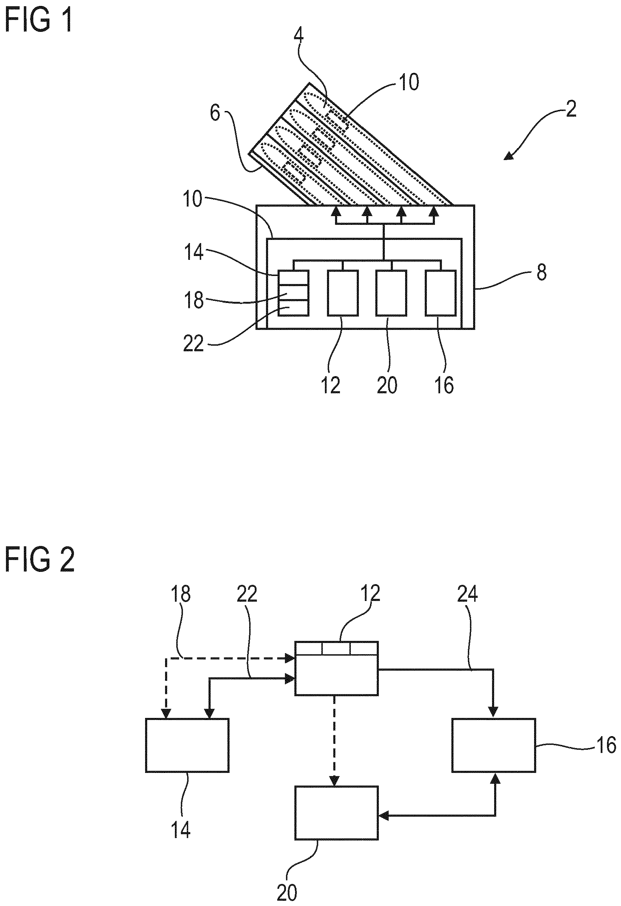

FIG 1 zeigt ein Flugabwehrsystem 2 mit mehreren Flugkörpern 4, die jeweils in einem Kanister 6 gelagert sind. Die Kanister 6 sind auf einem Fahrzeug 8 montiert, beispielsweise einem Lastkraftwagen oder einem Schiff, und können aus einer waagerechten Lagerposition in eine schräge oder senkrechte Abschussposition geschwenkt werden, wie in FIG 1 dargestellt ist.

Das Flugabwehrsystem 2 umfasst ferner ein Datenverarbeitungssystem 10 mit einem Prozessor beziehungsweise einer CPU 12, der datentechnisch mit einem nichtflüchtigen Datenspeicher 14 und einem flüchtigen Datenspeicher 16 verbunden ist. Der nichtflüchtige Datenspeicher 14 enthält Software 18 zum Starten des Datenverarbeitungssystems 10 und damit zum Herstellen der Arbeitsbereitschaft des Datenverarbeitungssystems 10 beziehungsweise Flugabwehrsystems 2. Das Datenverarbeitungssystem 10 ist signaltechnisch mit jedem einzelnen der mehreren Flugkörper 4 verbunden, wie in FIG 1 durch die Pfeile angedeutet ist. Mit Hilfe des Datenverarbeitungssystems 10 kann die Steuerung eines Abschusses der Flugkörper 4 erfolgen.

Zusätzlich zur CPU 12 ist ein FPGA 20 vorhanden, dessen Datenausgabe einen wesentlichen Teil der Steuerung des Flugabwehrsystems 2 beziehungsweise der einzelnen Flugkörper 4 bewirkt. Zur Konfiguration des FPGA 20 ist Software 22 vorhanden, die vor dem Start des Datenverarbeitungssystems 10 in komprimierter Form im nichtflüchtigen Datenspeicher 14 vorliegt. CPU 12 und FPGA 20 bilden ein sogenanntes Embedded System auf einer gemeinsamen Platine.

Grundsätzlich ist es auch möglich, dass jeder der Flugkörper 4 ein wie oben beschriebenes Datenverarbeitungssystem 10 aufweist. Das Flugabwehrsystem 2 kann dann entweder einfacher ausgeführt sein, da komplexe Steuervorgänge im Flugkörper 4 selbst erfolgen, oder sowohl der Flugkörper 4 als auch das Flugabwehrsystem 2 enthalten jeweils ein wie oben beschriebenes Datenverarbeitungssystem 10. Hierbei können die Steuervorgänge beim Start eines Flugkörpers 4 auf die beiden Datenverarbeitungssysteme 10 im Flugkörper 4 und im Flugabwehrsystem 2 verteilt sein. Auch möglich ist, dass das Datenverarbeitungssystem 10 des Flugabwehrsystems 2 den Start steuert und das Datenverarbeitungssystem 10 den weiteren Flug des Flugkörpers. Im Folgenden werden die im Datenverarbeitungssystem 10 ablaufenden Vorgänge für alle dieser Fälle beschrieben.

Soll ein Flugkörper 4 gestartet werden, so kann es sein, dass der Startvorgang sehr schnell ausgeführt werden muss, da eine Bedrohung nur wenig Zeit für eine Verteidigung lässt. Das Datenverarbeitungssystem 10 muss gebootet werden, bevor es die für den Start notwendigen Steuerbefehle ausgeben kann. Nach dem Booten steuert das Datenverarbeitungssystem 10 den Start des Flugkörpers 4. Ein Flug des Flugkörpers 4 kann von einem Datenverarbeitungssystem 10 im Flugkörper gesteuert werden.

Eine schematische Darstellung des Bootens des Datenverarbeitungssystems 10 ist in FIG 2 gezeigt. Zum Booten wird das Datenverarbeitungssystem 10 und damit die CPU 12 und die beiden Datenspeicher 14, 16 jeweils mit ihrer Betriebsspannung versorgt. Daraufhin ruft die CPU 12 vom nichtflüchtigen Datenspeicher 14 die Software 18, beispielsweise einen Bootloader, auf, wie durch den gestrichelten Doppelpfeil zwischen CPU 12 und Datenspeicher 14 dargestellt ist. Die CPU 12 kann ihre Cache-Speicher bereits integriert haben, wie durch die drei Felder im oberen Bereich der CPU für L1-Cache, L2-Cache und L3-Cache angedeutet ist. Auch der Cache bildet einen flüchtigen Datenspeicher.

Der Bootloader bewirkt, dass die Software 22, die als komprimierte Programmdaten im nichtflüchtigen Datenspeicher 14 vorliegen, in die CPU 12 geladen und dort in Zusammenarbeit mit dem flüchtigen Datenspeicher 16 entkomprimiert werden. Die CPU 12 ruft also die Programmdaten 22 aus dem nichtflüchtigen Datenspeicher 14 auf, wie durch den Doppelpfeil zwischen CPU 12 und Datenspeicher 14 dargestellt ist.

Die entkomprimierten Programmdaten 24 sind in diesem Ausführungsbeispiel FPGA-Firmware. Sie werden in den flüchtigen Datenspeicher 16 abgelegt, und es wird gewartet, bis die Programmdaten 22 entweder insgesamt oder in einzeln arbeitenden Programmteilen entkomprimiert und abgelegt sind. Dann wird der FPGA 20 von der CPU 12 eine Adressmitteilung gemacht und der Ladebefehl gegeben. Dies ist durch den gestrichelten Pfeil von CPU 12 zum FPGA 20 dargestellt. Der FPGA 20 ruft die entkomprimierten Programmdaten 24 aus dem flüchtigen Datenspeicher 16 ab und konfiguriert sich mit diesen, wie durch den Doppelpfeil zwischen FPGA 20 und Datenspeicher 16 dargestellt ist.

Nach Abschluss dieses Bootens des Datenverarbeitungssystems 10 übernimmt dieses die Steuerung der Flugkörper 4 beziehungsweise deren Starts. Hierfür können weitere entkomprimierte Programmdaten 24 nun zu einem Programmstart aufgerufen werden und mit ihnen kann der Programmstart beziehungsweise die Durchführung der Steuerung bewirkt werden.

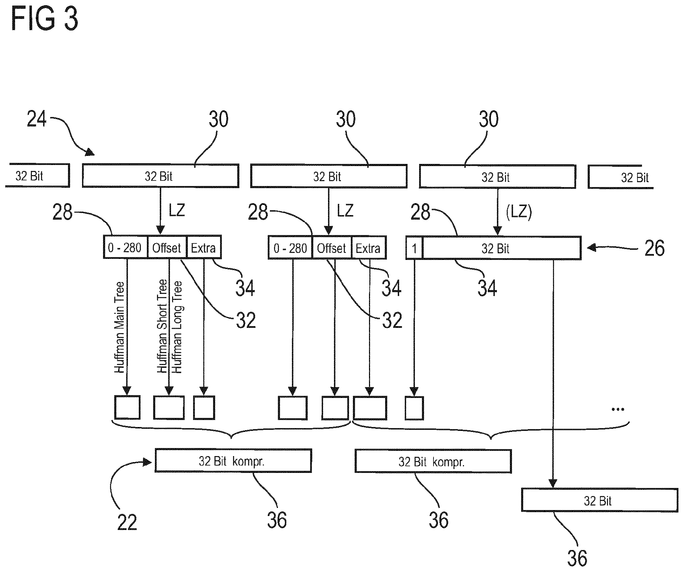

Zum Herstellen der Lauffähigkeit der Programmdaten 22 müssen diese erst entkomprimiert werden. FIG 3 zeigt das Komprimierungs- beziehungsweise Entkomprimierungsverfahren für diese Programmdaten 22. Schematisch dargestellt sind die komprimierten Programmdaten 22, wie sie in Wörtern 36 vorliegen und im nichtflüchtigen Datenspeicher 14 abgelegt sind. An sich liegen die komprimierten Programmdaten 22 als ein einziger Block komprimierter Daten vor. Dieser Datenblock ist jedoch unterteilt in eine Vielzahl von jeweils von 4 Byte großen Einheiten oder Wörtern 36, wie es im unteren Teil von FIG 3 schematisch durch die Trennung in jeweils 32 Bit große Wörter 36 dargestellt ist. Die kleinste Dateneinheit in den komprimierten Daten 22 ist insofern das 32 Bit große Wort, das 4 Byte an Speicherplatz einnimmt. Das Gleiche gilt auch für die entkomprimierten Programmdaten 24, die ebenfalls als ein einziger Datenblock vorliegen, der jedoch auch in 4 Byte große Einheiten beziehungsweise Wörter 30 aufgeteilt ist. Diese Dateneinteilung erlaubt, eine effiziente Datenverarbeitung, die eine langsamere Byte große Datengranularität vermeidet.

Zum einfacheren Verständnis des Verfahrens der Entkomprimierung der komprimierten Programmdaten 22 in die entkomprimierten Programmdaten 24 sei zunächst die Datenkomprimierung beschrieben.

Zunächst werden die unkomprimierten Programmdaten 24 mit einem Kompresssionsverfahren der LZ-Familie, beispielsweise LZ77, auf eine Zwischenstufe 26 komprimiert. In einem zweiten Schritt werden die so vorkomprimierten Programmdaten mit einer Huffman-Komprimierung komprimiert, wie in FIG 3 schematisch dargestellt ist. Bei der entsprechenden Entkomprimierung werden die komprimierten Programmdaten 22 zunächst mittels Huffmanverfahren beziehungsweise Huffmanbäumen auf die Zwischenstufe 26 entkomprimiert, in der die Daten in Token-Form vorliegen, also als eine Reihenfolge von Token 28. Vor dieser Zwischenebene 26 werden die Daten mittels LZ-Entkomprimierung in die entkomprimierten Programmdaten 24 umgewandelt.

Der komprimierte Datenblock, der die vollständigen Programmdaten 22 zum Starten eines Programms enthält, beispielsweise zum Konfigurieren des FPGA 20, besteht aus 3 Teilen: einem Header, der zumindest eine Eigenschaft sowohl des komprimierten als auch des unkomprimierten Datenblocks beschreibt, dann einem Modellteil, der drei Huffmanbäume enthält, und als dritten Teil die eigentlichen komprimierten Daten, aus denen die entkomprimierten Programmdaten 24 wiederhergestellt werden. Beide Datenblöcke 22, 24 bestehen jeweils aus einer Vielzahl von 32-Bit Wörtern 36, 30.

Die Zwischenebene 26, die nach den ersten Komprimierungsverfahren vorliegt, besteht aus einer Sequenz von Token 28, die jeweils einen ersten Teil aufweisen, der die Tokenart angibt. In dem gezeigten Ausführungsbeispiel gibt es 281 Tokenarten, die von 0 bis 280 durchnummeriert sind. An diesen ersten Teil können sich maximal zwei weitere Teile anschließen, deren Länge und Inhalt von der Tokenart abhängig ist. Ein weiterer Teil der Token 28 kann insofern einen Offset 32 angeben oder ein gesamtes unkomprimiertes 32 Bit langes Wort. Je nach Tokenart ist auch ein dritter Teil mit Extrabits 34 möglich. Die Tokenarten gruppieren sich in 4 Kategorien: Zeichengetreue Wiedergabe, Einwortwiederholung, Mehrwortwiederholungen oder Kette gleicher Wörter.

Im zweiten Komprimierungsschritt werden diese Token 28 mit Hilfe von mehreren Huffmanbäumen weiter komprimiert. Ein erster Huffmanbaum gibt die Tokenart an und umfasst in seiner Baumstruktur mithin sämtliche Tokenarten. Zusätzlich zu diesem Hauptbaum gibt es einen oder mehrere Huffmanbäume, in diesem Ausführungsbeispiel zwei Bäume, mit denen der Offsetteil 32 weiter komprimiert wird. Die Extrabit 34 werden im zweiten Komprimierungsverfahren nicht weiter komprimiert. Jeweils für die Einwortwiederholungen und für die Mehrwortwiederholungen wird ein separater Huffmanbaum für die zweite Komprimierung verwendet.

Die Entkomprimierung kann in einem Streaming erfolgen. Der Dekomprimierer, beispielsweise die CPU 12, kann die komprimierten Programmdaten 22 in einem einzigen Durchgang vom Start bis zum Ende einlesen, ohne auf den flüchtigen Datenspeicher 16 zugreifen zu müssen. Die Ausgabe der entkomprimierten Programmdaten 24 kann ebenfalls in einer Streaming-Art erfolgen, wobei jedoch das Zugreifen auf den flüchtigen Datenspeicher 16 notwendig ist, um zuvor entkomprimierte Wörter 30 zu kopieren. In den allermeisten Fällen liegen die zu kopierenden Wörter 30 jedoch so nahe, dass sie noch im L2-Cache liegen, sodass ein sehr schneller Zugriff möglich ist.

Die vollständigen unkomprimierten Programmdaten 24 werden durch eine Sequenz von Token 28 in der Zwischenebene 26 der Komprimierung wiedergegeben. Jeder Token 28 gehört zu einer der vier Tokenkategorien. Ein Token aus der Kategorie der zeichengetreuen Wiedergabe besteht aus einem ganzen unkomprimierten Wort 30 oder aus einem Teil von diesem, wenn der restliche Teil des Worts 30 ausschließlich aus Nullen oder Einsen vor oder hinter dem zeichengetreu wiedergegebenen Wortteil besteht.

Ein Token 28 der Kategorie der Einwortwiederholungen gibt ein Wort wieder, das im Verfahren der Entkomprimierung bereits vorhergehend entkomprimiert wurde, also eine Wortwiederholung in den unkomprimierten Programmdaten 24. Diese Tokenkategorie enthält auch Token 28, die eine Wortwiederholung mit einem Unterschied von einem oder zwei Bit zum bereits entkomprimierten fast gleichen Wort 30 bilden.

In der Tokenart der Mehrwortwiederholungen gibt es nur solche Token 28, die jeweils exakt mehrere hintereinander liegende Wörter wiederholen, die bereits zuvor entkomprimiert wurden. Token 28 der Mehrwortwiederholungen referieren also zu einer Reihe von zwei oder mehr bereits entkomprimierten Wörtern 30, die sich in den unkomprimierten Programmdaten 24 genau in dieser Weise wiederholen.

Die Tokentypen der Kategorie der Kette gleicher Wörter stehen für eine oder mehrere Wiederholungen eines einzigen Worts 30 unmittelbar vor dem zu entschlüsselnden Wort 30, das durch das Token 28 repräsentiert wird.

Im Folgenden ist eine Tabelle aller verwendeten Tokenarten der Kategorie der zeichengetreuen Wiedergabe angegeben.

*Tabelle 1: Token der Kategorie der zeichengetreuen Wiedergabe*

| Tokentyp | Hauptsymbol (S) | Anzahl der Extrabits (B) | Wort |
|---|---|---|---|
| Zero | 0 | 0 | 0 |
| Verbatim | 1 | 32 | $B$ |
| Short | 67-87 | $S$-67 | $2^{S-67} + B$ |
| Sparse | 88-108 | $S$-88 | $B \times 2^{32-(S-88)} + 2^{32-(S-88)-1}$ |
| Short Negative | 109-129 | $S$-109 | $-(2^{S-67}+B)$ |
| Sparse Negative | 130-150 | $S$-130 | $-(B \times 2^{32-(S-88)}+2^{32-(S-88)-1})-1$ |

In der ersten Spalte ist der Tokentyp angegeben. In der zweiten Spalte ist das Hauptsymbol S angegeben, das im zweiten Teil der Huffmankomprimierung verwendet wird. Jede Tokenart hat ein eigenes Hauptsymbol S. Die Hauptsymbole liegen in diesem Ausführungsbeispiel in Form einer Zahl von 0 bis 280 vor. Dies ist jedoch nur beispielhaft beschrieben, sodass anstelle der im Folgenden wiedergegebenen konkreten Zahlen auch ein anderes Hauptsymbol stehen kann.

Die Tabelle enthält also eine Tokenkategorie mit sechs Tokentypen, die zusammen 86 Tokenarten umfassen, die also 86 Hauptsymbole belegen. Jede Tokenart - bis auf die Tokenart "Zero" - hat viele Möglichkeiten für Token 28, die sich aus einem oder mehreren Extrabits ergeben. Die Anzahl Extrabits in den einzelnen Tokentypen sind in der dritten Spalte wiedergeben. Die vierte Spalte gibt das unkomprimierte Wort 30 der Programmdaten 24 wieder.

Der erste Tokentyp "Zero", der in diesem Ausführungsbeispiel das Hauptsymbol 0 trägt, hat nur eine einzige Tokenart, die ein unkomprimiertes Wort 30 angibt, das lediglich aus Nullen besteht. Die entsprechende Tokenart besteht insofern nur aus einem einzigen Token 28 mit einem ersten Teil, der wiederum nur aus einer Null besteht.

Der Tokentyp "Verbatim" steht für die zeichengetreue Wiedergabe von 32 Bit eines Worts 30. Die entsprechenden Token 28 bestehen aus einem ersten Teil, der aus lediglich einer 1 als Hauptsymbol besteht, und 32 Bit zeichengetreuer Wiedergabe. Ein solcher Token 28 ist beispielhaft in FIG 3 als drittes Token 28 dargestellt.

Der Tokentyp "Short" umfasst mehrere Tokenarten, in dem hier beschriebenen Ausführungsbeispiel 21 Tokenarten. Jede Tokenart steht für ein Wort mit einer vorgegebenen Anzahl vorne stehender Nullen und einem dahinter liegenden Verbatim-Teil, also einem Teil, der zeichengetreu durch Extrabits angegeben wird. Die Anzahl der vorstehenden Nullen ergibt sich aus dem Hauptsymbol S.

Besteht beispielsweise ein unkomprimiertes Wort 30 aus einem hinteren Teil mit 7 Bits, deren vorderstes Bit eine 1 ist, und einem vorderen Teil aus 25 Bit, die lediglich Nullen sind, so reichen sechs Extrabit aus, um das Wort 30 vollständig zu beschreiben. Die sechs Extrabits geben die letzten sechs Bit des Worts 30 an, das Bit davor muss eine 1 sein, und die davor liegenden 25 Bit sind Nullen. Ein solches Wort 30 trägt das Hauptsymbol S = 73, wobei die Anzahl der Extrabit 34 sich beläuft auf S - 67 = 6. Das unkomprimierte Wort 30 besteht entsprechend der letzten Spalte aus der Zahl $2^6$ + B, wobei B die letzten sechs Zeichen angibt.

Der vierte Tokentyp "Sparse" beschreibt jeweils ein Wort 30, dessen hinterer Teil aus einer Reihe von Nullen besteht. Der davorliegende Teil wird - bis auf die von hinten gesehen erste 1 - als zeichengetreue Wiedergabe mithilfe von Extrabits wiederholt. Wie bei "Short" gibt es auch bei "Sparse" die gleiche Anzahl von Tokenarten, in diesem Ausführungsbeispiel 21 Tokenarten. Jede Tokenart steht für die Anzahl der vorweg stehenden ("Short") beziehungsweise hinten stehenden ("Sparse") Nullen des Worts 30. Durch das Hauptsymbol S ist insofern die Anzahl der vorhergehenden beziehungsweise hinten anstehenden Nullen eindeutig vorgegeben.

Die beiden Tokentypen "Shorts negative" und "Sparse negative" sind exakt wie "Short" und "Sparse", wobei jedoch die vorne stehenden oder hinten angestellten Zahlen nicht Nullen sondern Einsen sind.

Allgemein gesprochen, enthält die Tokenkategorie der zeichengetreuen Wiedergabe beliebige mehrere oder alle der sechs Tokentypen, von denen zwei nur eine Tokenart und vier Tokentypen jeweils eine Mehrzahl von verschiedenen Tokenarten enthalten, wobei die Anzahl der enthaltenen Tokenarten gleich sein kann, wie in diesem Ausführungsbeispiel jeweils 21. Die Tokenarten enthalten eine Anzahl von 0 bis 32 Extrabit, die die Länge des Wortteils wiedergeben, der zeichengetreu wiederholt wird. Dieser Wortteil kann das gesamte Wort 30 umfassen (Verbatim) oder nicht vorhanden sein (Zero) oder nur einen Wortteil kleiner als 32 Bit umfassen, wobei das restliche Wort aus Nullen oder Einsen vor oder hinter diesem Wortteil besteht.

Eine Tabelle mit Tokenarten aus der Kategorie der Einwortwiederholungen ist im Folgenden wiedergegeben.

*Tabelle 2: Token der Kategorie der Einwortwiederholungen*

| Tokentyp | Hauptsymbol (S) | Entkomprimiertes (X = Source Word, O = Offset) |
|---|---|---|
| Verbatim | 2 | $X$ |
| 1-Bit Delta | 3-34 | $X \oplus 2^{S-3}$ |
| 2-Bit Delta | 35-65 | $X \oplus (3 \times 2^{S-35})$ |
| ARM Branch | 66 | $0 \times EB000000 + ((X - O) \bmod 2^{24})$ |

In diesem Ausführungsbeispiel enthält diese Tokenkategorie vier Tokentypen. Der erste Tokentyp "Verbatim" mit dem Hauptsymbol S = 2 hat nur eine einzige Tokenart, die exakt ein bereits entkomprimiertes Wort 30 beschreibt. Die Tokenart umfasst insofern das Hauptsymbol S und als zweiten Teil einen Offset 34, der angibt, wie viele Wörter 30 zuvor dasjenige Wort 30 liegt, das wiederholt wird. Extrabit sind in Token 28 der Kategorie der Einwortwiederholungen nicht vorhanden. Der zweite Tokentyp "1-Bit Delta" gibt jeweils ein Wort 30 an, das um nur ein Bit von einem zuvor entkomprimierten Wort 30 abweicht. Es gibt 32 Möglichkeiten wo dieses Bit liegen kann. Entsprechend hat dieser Tokentyp 32 verschiedene Tokenarten, die mit einem der Hauptsymbole 3-34 bezeichnet sind. Insofern gibt das Hauptsymbol S eindeutig an, wo im Wort 30 die Ein-Bit-Differenz liegt.

In analoger Weise steht der Tokentyp "2-Bit-Delta" für ein Wort, das mit zwei hintereinander liegenden, also unmittelbar benachbarten Bits, von einem bereits entpackten Wort 30 unterschiedlich ist. Da es 31 Positionen gibt, wo dieses Bit-Paar stehen kann, hat dieser Tokentyp 31 Tokenarten.

Der vierte Tokentyp "ARM Branch" wandelt einen relativen Sprungbefehl in einem unkomprimierten Wort 30 in eine absolute Adresse um. In einem Programm wird häufig von unterschiedlichen Stellen an eine bestimmte Stelle im Programm gesprungen. Die entsprechenden Sprungbefehle sind als Relativsprünge in den unkomprimierten Programmdaten enthalten. Durch die Umwandlung in die absolute Adresse innerhalb der Programmdaten 24 sind diese Sprungbefehle alle gleich und hierdurch höher komprimierbar.

Zusammengefasst beschreiben Token 28 der Tokenarten der Kategorie der Einwortwiederholungen ein einziges Wort, das vorhergehend im unkomprimierten Datenblock bereits vorliegt. Diese Token 28 bestehen aus dem Hauptsymbol und dem relativen Offset. Solche Token 28 können optional Informationen enthalten, wo ein Bit oder zwei hintereinander liegende Bit Unterschied zwischen dem bereits entkomprimierten Wort und dem zu entkomprimierenden Wort vorliegt. Das Hauptsymbol trägt hierbei Information, wie das bereits entkomprimierte Wort zu verändern ist, um das aktuell zu entkomprimierende Wort wiederzugeben. Im Falle einer Änderung besteht diese Änderung aus der Invertierung von einem oder zwei Bit in dem zu kopierenden und bereits entkomprimierenden Referenzwort oder alternativ in einer Adresstransformation eines Sprungbefehls.

Eine Tabelle der Tokentypen der Kategorie der Mehrwortwiederholungen ist im Folgenden wiedergegeben.

*Tabelle 3: Token der Kategorie der Mehrwortwiederholungen*

| Tokentyp | Hauptsymbol (S) | Anzahl der Extrabits (B) | Wortzahl |
|---|---|---|---|
| Inline | 216-279 | 0 | $S - 216 + 2$ |
| External | 280 | 32 | $B$ |

Diese Tokentypen bestehen aus dem Hauptsymbol und einem Offset und eventuell einem oder mehreren Extrabit. Das Hauptsymbol gibt die Anzahl der Wörter 30 wieder, die zeichengenau und exakt in dieser Reihenfolge zu wiederholen sind. Der Offset gibt an, wo diese Reihe von zu wiederholenden Wörtern 30 relativ zu dem zu entkomprimierenden Wort 30 liegen, das sich in der entkomprimierenden Form in diese mehreren Wörter 30 erweitert.

Bei dem Tokentyp "Inline" beschreibt das Hauptsymbol S die Anzahl der Wörter 30, die wiederholt werden sollen. Das kleinste Hauptsymbol des Tokentyps, in diesem Fall 216, beschreibt insofern zwei Wörter 30, die wiederholt werden. Je höher das Hauptsymbol ist, desto mehr Wörter 30 werden wiederholt. Der Tokentyp "External" enthält nur eine einzige Tokenart, die neben dem Hauptsymbol, in diesem Fall 280, den Offset und eine Anzahl von Extrabit enthält, maximal 32 Extrabit. Diese Extrabit geben an, wie viel Wörter 30 wiederholt werden sollen. Auf diese Weise kann auch eine extrem lange Kette von beispielsweise von mehreren 1000 zu wiederholenden Wörtern 30, in einem einzigen Token 28 wiedergegeben werden.

Die Tokenarten der Kategorie der Mehrwortwiederholungen beschreiben insofern eine Sequenz von zwei oder mehr wiederholten Wörtern 30, die in einem Offset im bereits entkomprimierten Datenblock vorhanden sind. Diese Reihe von Wörtern 30 wird zeichengenau wiederholt ohne Änderungen.

Eine Tabelle der Tokentypen der Kategorie Kette gleicher Wörter ist in der folgenden Tabelle wiedergegeben.

*Tabelle 4: Token der Kategorie der Kette gleicher Wörter*

| Tokentyp | Hauptsymbol (S) | Anzahl der Extrabits (B) | Länge der Wortkette |
|---|---|---|---|
| Inline | 151-214 | 0 | $S - 151 + 1$ |
| External | 215 | 32 | $B$ |

Diese Tokentypen geben an, dass ein unmittelbar vorhergehend entkomprimiertes Wort wiederholt wird und wie oft es wiederholt wird. Tokenarten der Kategorie der Kette gleicher Wörter beschreiben also eine Sequenz eines einzigen Worts, das einmal oder mehrmals wiederholt wird. Das wiederholte Wort ist immer unmittelbar direkt nach dem letzten entkomprimierten Wort. Das Quellwort, das wiederholt wird, hat also den relativen Offset 1.

Der Tokentyp "Inline" gibt hierbei mit seinem Hauptsymbol S bereits an, wie oft das Wort wiederholt werden soll. Das Hauptsymbol 151 gibt beispielsweise an, dass das letzte Wort einmal wiederholt wird. Beim Hauptsymbol 152 wird das Wort zwei Mal wiederholt und so weiter. Da durch das Hauptsymbol S bereits angegeben ist, wie oft das Wort wiederholt werden soll, ist kein Extrabit notwenig. Extrabit werden erst dann notwendig, wenn die Anzahl der Wiederholungen des vorhergehenden Worts die Anzahl der zur Verfügung stehenden Hauptsymbole S übersteigt. In diesem Fall wird das Hauptsymbol 215 verwendet und eine Anzahl von Extrabit, maximal 32 Bit, die angeben, wie oft das Wort wiederholt werden soll.

Wie auch bei den Mehrwortwiederholungen gibt bereits die Tokenartkodierung, die durch das Hauptsymbol S erfolgt, bei einer Kette gleicher Wörter an, wie oft ein einziges Wort wiederholt werden soll, beziehungsweise bei den Mehrwortwiederholungen wie viele gegebenenfalls verschiedene Wörter hintereinander wiederholt werden. Bei einer größeren Anzahl von Wortwiederholungen wird die Extrabit-Codierung verwendet, auf die das entsprechende Hauptsymbol dann hinweist.

Die Token 28 aus der Zwischenebene 26 werden im zweiten Komprimierungsschritt mithilfe der Huffmankomprimierung komprimiert. Hierfür werden mehrere Huffmanbäume erzeugt, die am Anfang des komprimierten Datenblocks unkomprimiert angegeben sind. In diesem Ausführungsbeispiel werden drei Huffmanbäume verwendet. Das Hauptsymbol S der Token 28 wird mit einem Hauptbaum codiert beziehungsweise komprimiert. Zur Komprimierung des Offsets 32 stehen zwei Huffmanbäume zur Verfügung. Mit einem Huffmanbaum, in FIG 3 als "Short Tree" angegeben, werden die Offsets der Einwortwiederholungen codiert. Die Offsets der Mehrwortwiederholungen werden mit einem anderen Huffmanbaum codiert, der in FIG 3 "Long Tree" bezeichnet ist.

Welcher der Huffmanbäume zu verwenden ist, sowohl zur Komprimierung als auch zur Entkomprimierung, ergibt sich aus dem zuvor entkomprimierten Hauptsymbol S, mit dem die Kategorie des zu entkomprimierenden Token 28 festgelegt ist. Durch das Hauptsymbol ist auch festgelegt, ob Extrabit 34 vorhanden sind oder nicht. Auch die Anzahl der Extrabit 34 ist bereits durch das Hauptsymbol eindeutig wiedergegeben. Hierdurch ist die Gesamtlänge des Tokens 28 bekannt, sodass auch unmittelbar hintereinander angeordnete Token 28 eindeutig voneinander getrennt werden können.

Eine Tabelle aller Tokentypen aufgeschlüsselt nach dem Hauptsymbol S ist im Folgenden wiedergegeben.

*Tabelle 5: Hauptalphabet*

| Hauptsymbol (S) | Tokenkategorie | Tokentyp | Offset | Anzahl der Extrabits (B) |
|---|---|---|---|---|
| 0 | Zeichengetreu | Zero | 0 | 0 |
| 1 | | Verbatim | 0 | 32 |
| 2 | Einwort | Verbatim | + | 0 |
| 3-34 | | 1-Bit Delta | + | 0 |
| 35-65 | | 2-Bit Delta | + | 0 |
| 66 | | ARM Branch | + | 0 |
| 67-87 | Zeichengetreu | Short | 0 | $S - 67$ |
| 88-108 | | Sparse | 0 | $S - 88$ |
| 109-129 | | Short Negative | 0 | $S - 109$ |
| 130-150 | | Sparse Negative | 0 | $S - 130$ |

(fortgesetzt)

| Hauptsymbol (S) | Tokenkategorie | Tokentyp | Offset | Anzahl der Extrabits (B) |
|---|---|---|---|---|
| 151-214 | Kette | Inline | 0 | 0 |
| 215 | | External | 0 | 32 |
| 216-279 | Mehrwort | Inline | + | 0 |
| 280 | | External | + | 32 |

Es ist zu sehen, dass jedes Token 28 ein Hauptsymbol S aufweist, das mit dem Hauptbaum der Huffmankodierung komprimiert wird. In der vierten Spalte ist das Vorhandensein von Offset-Bits wiedergegeben, die durch ein "+" in der Tabelle angezeigt sind. Es ist zu sehen, dass nur Token 28 der Tokentypen der Ein- und Mehrwortwiederholungen jeweils einen Offset 32 aufweisen. Von diesen weist nur der Tokentyp mit dem Hauptsymbol 280 zusätzlich zum Offset auch Extrabits 34 auf. Alle anderen Token 28 weisen nur ein oder zwei Symbole auf, nämlich das Hauptsymbol S und bei einem zweiten Symbol entweder Offset 32 oder Extrabit 34. Zur Komprimierung eines Tokens 28 des Typs mit dem Hauptsymbol 0 ist beispielsweise nur das Hauptsymbol S zu komprimieren. Das gleiche gilt für die Token 28 des Typs mit dem Hauptsymbol 151-214.

Die maximale Länge der durch einen Huffmanbaum codierten Symbole ist auf 12 Bit für den Hauptbaum beschränkt und auf 10 Bit für die beiden Offset-Bäume. Obgleich diese Beschränkung zu einer leicht suboptimalen Codezuordnung bei der Huffman-Komprimierung führt, ermöglicht diese Beschränkung die Decodierung von allen Huffman-Codes mit der Verwendungen von drei einzelnen Nachschlagetabellen, die nur 12 Kilobyte Speicherplatz brauchen und üblicherweise in den L1 Cache der den Entkomprimierungsalgorithmus ausführenden CPU 12 passen.

Das durch den Hauptbaum der Huffman-Komprimierung komprimierte Hauptsymbol S ist immer der erste Teil eines jeden Tokens 28 in der komprimierten Form des Tokens 28. Dieses Symbol S legt eindeutig die nächsten Schritte der Entkomprimierung des gesamten Tokens 28 fest.

Die Größe der Offsets 32 ist bei Einwortwiederholungen mindestens 1 und bei Mehrwortwiederholungen mindestens 2. Der größte Offset 32 liegt bei Einwortwiederholungen bei 4.096. Das heißt, dass Einwortwiederholungen üblicherweise mit dem Datenbestand aus dem L1 Cache ausgeführt werden können, sofern dieser die letzten 4.096 Wörter beinhaltet. Hierdurch ist die Dekomprimierung sehr schnell. Das Offset-Modell ist in folgender Tabelle wiedergegeben.

*Tabelle 6: Offsetalphabet*

| Offsetsymbol (S) | Kategorie | Offset Encoding | Anzahl der Extrabits (B) | Offset (m = Minimaloffset) |
|---|---|---|---|---|
| 0-31 | Ein- und Mehrwort | Direct | 0 | $S + m$ |
| 32-39 | | Dictionary | 0 | $D(S - 32)$ |
| 40-151 | | Grouped | $n = G + 1$ | (3) |
| 152-199 | Mehrwort | Grouped | $n = G + 1$ | (3) |
| 200 | | Verbatim | 32 | $B$ |

Aus der Tabelle ist zu sehen, dass der Offset 32 nur in Einzelfällen direkt angegeben ist, wie in der ersten Zeile zu sehen ist. Ein Offset 32 von 1 bis 32 Wörtern trägt das Offset-Symbol 0 bis 31 und wird direkt angegeben. Eine solche Angabe von größeren Offsets 32 wäre sehr speicherintensiv. Insofern wurde eine neue Offset-Gruppe geschaffen, die in diesem Ausführungsbeispiel den Namen "Dictionary" trägt. Diese Offset-Gruppe besteht aus einer Reihe von vorab festgelegten Offsets 32, die nicht hintereinander liegen. Zweckmäßigerweise werden solche Offsets 32 gewählt, die oft vorkommen und die auf diese Weise einfach codiert werden können. Aus solchen Offsets 32, die bei der Komprimierung überdurchschnittlich oft angewendet werden, wird eine vorbestimmte Anzahl Offsets 32, beispielsweise 8 Offsets ausgewählt, und jeweils mit einem festen Offset-Symbol belegt. Solche Offsets 32 können in einem sogenannten Offset-Wörterbuch wiedergegeben sein.

Bei gruppierten Offsets 32 gibt das Offsetsymbol nur eine Gruppe von Offsets 32 an, also einen Offsetbereich. Der genaue Offset 32 kann durch Extrabits festgelegt werden, wie beispielsweise in der Tabelle des Offset-Alphabets angegeben ist, wobei G mit folgender Formel beschrieben werden kann:

$$G = \left\lfloor \frac{S - 40}{2^4} \right\rfloor$$

Der Offset 32 ergibt sich hierbei aus folgender Gleichung:

$$O = (2^G - 1) \times 2^5 + 2^n \times ((S - 40) \bmod 2^4) + B + 32 + m$$

Einzelne besonders große Offsets 32 können durch ein eigenes Offset-Symbol, in diesem Fall 200, belegt sein und durch 32 Extrabit genau angegeben sein. Hierdurch kann ein Offset 32 bis 4 Gigabyte beschrieben werden.

Der komprimierte Datenblock aus komprimierten Programmdaten 22 trägt an seinem Anfang einen Header aus beispielsweise 7 Wörtern mit jeweils 32 Bit. Die nachfolgende Tabelle beschreibt die Felder beziehungsweise einzelnen Wörter des Headers.

*Tabelle 7: Komprimierter Header*

| Wort | Inhalt | Beschreibung |
|------|--------|--------------|
| 0 | 0x2EB9A007 | Signature / Byte order mark |
| 1 | 4 | Algorithm identifier |
| 2 | | Uncompressed word count |
| 3 | | Compressed model word count following header |
| 4 | Variable | Compressed data word count following model |
| 5 | | Uncompressed data checksum |
| 6 | | Header checksum |

Durch die im Header angegebenen Daten soll eine Datenkorrumpierung durch eine fehlerhafte Übertragung, Komprimierung oder Entkomprimierung entdeckbar sein. Auf diese Weise können Fehler zügig und zuverlässig entdeckt werden und eine entsprechende Fehlermeldung kann ausgegeben werden. Nach dem Header liegt eine Sequenz von Wörtern, die die drei Huffmanbäume wiedergeben und auch die Einträge der Offset Wörterbücher, die für die Entkomprimierung häufig vorkommender Offsets von Ein- und Mehrwortwiederholungen beinhalten. Diese Modelldatensequenz besteht aus einer Serie von Bit-Sequenzen vorgegebener Länge, die in 32 Bit-Wörter aufgeteilt sind. Jede Bit-Sequenz stellt einen Maschineninteger dar, wobei das wichtigste Bit als erstes liegt. Die Bitreihenfolge 1101 repräsentiert insofern den Wert 13. Bit-Sequenzen sind in der Reihenfolge vom hochwertigsten zum niederwertigsten Bit in Wörter gepackt, wobei sie eine Wortgrenze überschreiten können. Das letzte Wort wird - falls notwendig - mit Nullen aufgefüllt. Die Modellreihenfolge ist wie folgt festgelegt:

1. Offset-Wörterbuch der Einwortwiederholungen
2. Offset-Wörterbuch der Mehrwortwiederholungen
3. Huffman-Hauptbaum
4. Huffman-Offset-Baum für Einwortwiederholungen
5. Huffman-Offset-Baum für Mehrwortwiederholungen

Die Datenlängen der drei Huffmanbäume sind in eine einzige Sequenz zusammenführt, die aus 634 Datenlängen zwischen 0 und 12, beziehungsweise 10 für die Offset-Bäume, besteht. Eine Datenlänge von 0 bedeutet, dass das korrespondierende Symbol nicht benutzt ist und daher nicht im Huffmanbaum zu finden ist.

Wie aus FIG 3 zu sehen ist, sind die komprimierten Programmdaten 22 in zwei ineinander verschachtelten Sequenzen angeordnet. Die erste Sequenz enthält die durch die Huffmanbäume komprimierten Symbole und solche nicht durch eine Huffmankomprimierung gegangenen Extrabits, deren Länge unterhalb von 32 Bit ist. Die entsprechend kodierten Daten sind hintereinander angeordnet und zu 32 Bit-Wörtern gruppiert, wie in FIG 3 dargestellt ist. Die zweite Sequenz beinhaltet ganze 32-Bit-Wörter 36. Wird beispielsweise in einer zeichengetreuen Wiedergabe ein ganzes Wort 36 aus 32 Bit weder durch die LZ-Komprimierung noch durch die Huffman-Kompression codiert, so füllt dieses Wort 36 ein Wort 36 der zweiten Sequenz. Eine solche verschachtelte Anordnung von Wörtern 36 beider Sequenzen minimiert die Anzahl von Speicherzugriffen innerhalb des Entkomprimierungsverfahrens.

Ein unkomprimiertes 32-Bit-Wort 36 der zweiten Sequenz folgt einem solchen Wort 36 der ersten Sequenz, in das das unkomprimierte Wort 30 der zweiten Sequenz hineingehören würde, wenn man die Datenreihenfolge der unkomprimierten Programmdaten 24 betrachtet. Allerdings wird dieses Wort 36 der zweiten Sequenz nicht in das entsprechende Wort 36 der ersten Sequenz eingefügt, sondern erst an dessen Ende angehängt. Liegen zwei unkomprimierte Wörter 36 hintereinander, so werden diese beiden Wörter 36 als Zwischenwörter hinter das entsprechende Wort 36 der ersten Sequenz angehängt.

Der vollständige Datenblock aus komprimierten Programmdaten 22 kann zudem in mehrere Unterblöcke aufgeteilt sein. Hierbei gleicht die Anzahl solcher Datenblöcke zweckmäßigerweise der der Rechenkerne der CPU 12. Auf diese Weise können zwei oder mehr komprimierte Datenblöcke parallel durch dieselbe Anzahl von Rechenkernen der CPU entkomprimiert werden. Dies hat den Vorteil, dass wann immer der L2-Cache des Embedded System eine neue Cache-Zeile vom nichtflüchtigen Datenspeicher 14 anfordert, ein anderer CPU-Kern mit der Entkomprimierung der Daten, die bereits im L2-Cache sind, fortfahren kann. Die Entkomprimierung der Datenblöcke überlappt sich daher, was zur Reduzierung von Lade- und Entkomprimierungszeit bis fast zur puren Transferzeit der Programmdaten 22 vom nichtflüchtigen Datenspeicher 14 zur CPU 12 führen kann.

Um diese parallele Entkomprimierung effizient zu gestalten, ist es sinnvoll, den Datenblock der unkomprimierten Programmdaten 24 in solche Teile beziehungsweise Datenblöcke aufzuteilen, die im komprimierten Zustand zumindest annähernd gleich groß sind, beispielsweise einen Größenunterschied von maximal 10 % haben. Die Datengröße der mehreren Blöcke in unkomprimierter Form kann natürlich sehr unterschiedlich sein. Ein Anhaltspunkt kann die Anzahl der Token 28 in der Zwischenebene 26 bieten. Beispielsweise weisen die mehreren Datenblöcke die gleiche oder eine ähnliche Anzahl von Token 28 auf, wobei die Anzahl der Token 28 maximal 10 % unterschiedlich zwischen den mehreren Datenblöcken ist.

Zur Entkomprimierung der Programmdaten 22 werden die Wörter 36 der komprimierten Programmdaten 22 aus dem nichtflüchtigen Datenspeicher 14 sukzessive in die CPU 12 übertragen. Dort werden die einzelnen Wörter 36 entsprechend der eindeutigen Huffmankodierung unter Zuhilfenahme der Huffmanbäume in die Zwischenebene 26 entkomprimiert, sodass die komprimierten Wörter 36 in eine Sequenz von Token 28 umgewandelt werden. Nun wird diese Sequenz Token für Token nacheinander entkomprimiert entsprechend des zur Komprimierung verwendeten LZ-Komprimierungsverfahrens. Die unkomprimierten Wörter 30 werden entsprechend der Reihenfolge der Token 28 erzeugt und bilden die Programmdaten 24. Mit diesen kann beispielsweise der FPGA 20 konfiguriert werden.

Diese Entkomprimierung beinhaltet im ersten Schritt der Huffman-Entkomprimierung eine Ein-Schritt-Entkomprimierung der Huffmanbaum-Symbole unter Verwendung von Nachschlagetabellen. Ein effizienter Weg zur Konstruktion solcher Nachschlagetabellen ist ihr Format in drei Felder von 4.096 oder 1.024 16-Bit Werten, je nach verwendetem Huffmanbaum.

Auch die Dekodierung beziehungsweise Entkomprimierung der Token 28 ist effizient, da die vollständige Information eines Tokens 28 beschränkt ist auf meistens 32-Bit variable Länge und bis zu zwei weiteren 32-Bit zeichengetreuen Wörtern 30. Insofern reichen die Daten einer einzigen Pufferspeicherfüllung, um den gesamten Token 28 zu entkomprimieren.

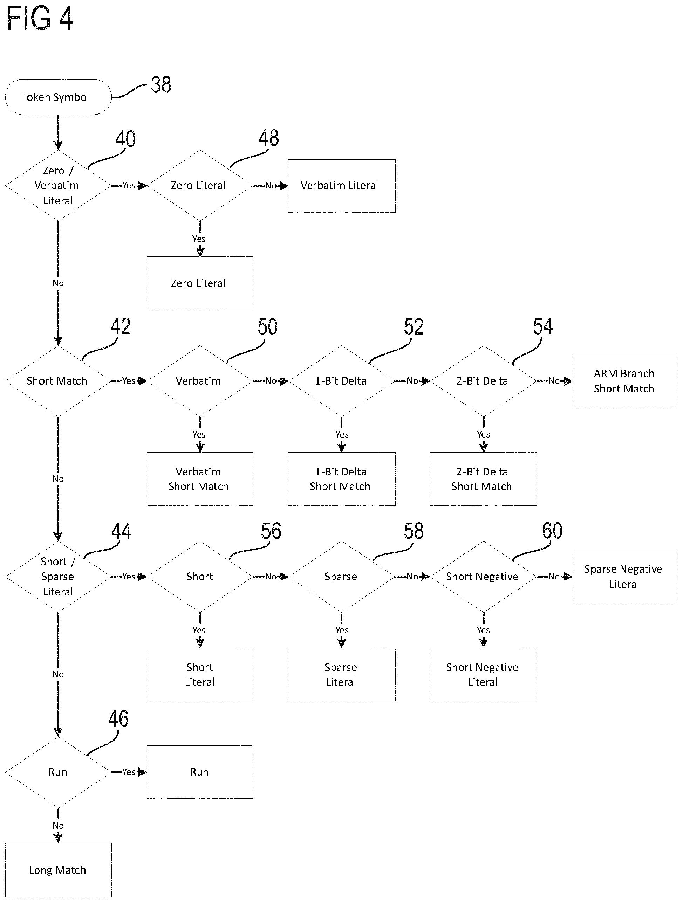

Bei der Entkomprimierung eines Tokens 28 wird zuerst das Hauptsymbol S entkomprimiert, um die Tokenart zu bestimmen. Je nach Art der Token 28 kann dies zu einer größeren Anzahl von Verzweigungen führen und damit verhältnismäßig zeitintensiv sein. Es ist daher vorteilhaft, die Entkomprimierungsentscheidungen so anzuordnen, dass ihre Reihenfolge der Wahrscheinlichkeit des Auftretens der verschiedenen Tokenarten gleicht. FIG 4 zeigt eine geeignete Reihenfolge einer solchen Verzweigung.

FIG 4 zeigt ein Flussdiagramm eines Verfahrens zur Entkomprimierung von Token 28. Zunächst wird in Schritt 38 das Tokensymbol beziehungsweise Hauptsymbol S eingelesen. Anschließend wird in den Schritten 40 bis 46 die Tokenart abgefragt beginnend mit solchen Tokenarten, die unter den Token 28 am häufigsten auftreten. Die Reihenfolge entspricht auch dem Hauptalphabet aus der obigen Tabelle 5. Zuerst werden Tokentypen der Kategorie der zeichengetreuen Wiedergabe abgefragt. Dann Tokentypen aus Einwortwiederholungen, dann die restlichen Tokentypen aus der Kategorie der zeichengetreuen Wiedergabe, und zum Schluss die Tokentypen der Kette gleicher Wörter. Die letzten Tokentypen aus den Mehrwortwiederholungen ergeben sich als verbleibender Rest aller Tokentypen. Ist durch eine positive Abfrage in den Abzweigungen 40 bis 46 die Tokenkategorie beziehungsweise Klasse der Tokentypen gefunden, so wird in weiteren Abfragen 48 bis 60 der exakte Tokentyp ermittelt. Aufgrund dieser Abfragereihenfolge kann der Tokentyp zeiteffizient ermittelt werden.

Bezugszeichenliste

2        Flugabwehrsystem
4        Flugkörper

| 6 | Kanister |
|---|---|
| 8 | Fahrzeug |
| 10 | Datenverarbeitungssystem |
| 12 | CPU |
| 14 | nichtflüchtiger Datenspeicher |
| 16 | flüchtiger Datenspeicher |
| 18 | Software |
| 20 | FPGA |
| 22 | Programmdaten |
| 24 | Programmdaten |
| 26 | Zwischenebene |
| 28 | Token |
| 30 | Wort |
| 32 | Offset |
| 34 | Extrabit |
| 36 | Wort |
| 38 | Einlesen Tokensymbol |
| 40 - 60 | Abzweigung |

**Patentansprüche**

1. Verfahren zum Booten eines Datenverarbeitungssystems (10), bei dem ein Boot Loader (18) aus einem nichtflüchtigen Datenspeicher (14) zu einer CPU (12) übertragen wird, dieser das Datenverarbeitungssystem (10) bootet und veranlasst, dass komprimierte Programmdaten (22) aus dem nichtflüchtigen Datenspeicher (14) durch die CPU (12) entkomprimiert werden und sie entkomprimiert in einen flüchtigen Datenspeicher (16) abgelegt werden, sie von dort zu einem Programmstart aufgerufen und mit ihnen ein Programm ausgeführt wird.

2. Verfahren nach Anspruch 1,
   **dadurch gekennzeichnet,**
   **dass** die Programmdaten (22) FPGA-Firmware sind, mit denen ein FPGA (20) konfiguriert wird.

3. Verfahren nach Anspruch 1 oder 2,
   **dadurch gekennzeichnet,**
   **dass** die Programmdaten (22) sowohl in komprimierter Form im nichtflüchtigen Datenspeicher (14) als auch in entkomprimierter Form im flüchtigen Datenspeicher (16) ausschließlich als Wörter (30, 36) in Multibytegröße gleicher Größe vorliegen.

4. Verfahren nach einem der vorhergehenden Ansprüche,
   **dadurch gekennzeichnet,**
   **dass** die Programmdaten (22) mittels eines ersten Komprimierungsverfahrens der LZ-Familie und anschließender Huffmankomprimierung komprimiert sind und mit den entsprechenden Verfahren entkomprimiert werden.

5. Verfahren nach einem der vorhergehenden Ansprüche,
   **dadurch gekennzeichnet,**
   **dass** die Programmdaten (22) entropiekodiert sind und sämtliche zum Starten des Datenverarbeitungssystems (10) verwendeten Daten mithilfe von maximal drei Huffmanbäumen entkomprimiert werden, wobei bevorzugterweise einer der Huffmanbäume zur Bestimmung einer Tokenart und mindestens ein weiterer Huffmanbaum zur Bestimmung der Rückwärtsoffsets zu gleichartigen Daten verwendet wird.

6. Verfahren nach einem der vorhergehenden Ansprüche,
   **dadurch gekennzeichnet,**
   **dass** die Entkomprimierung maximal drei einstufige Lookup-Tabellen verwendet, die jeweils aus einem Feld aus maximal 4.096 16-Bit-Werten bestehen.

7. Verfahren nach einem der vorhergehenden Ansprüche,
   **dadurch gekennzeichnet,**
   **dass** die komprimierten Programmdaten (22) einen vollständigen Programmdatensatz bilden, der zur Entkomprimierung ausschließlich durch den L1-Cache der CPU (12) geführt wird, wobei Rückgriffe auf bereits entkomprimierte Daten zur weiteren Entkomprimierung der Programmdaten (22) zumindest überwiegend auf den L2-Cache der CPU (12) erfolgen.

8. Verfahren nach einem der vorhergehenden Ansprüche,
**dadurch gekennzeichnet,**
**dass** zur Entkomprimierung Token (28) verwendet werden, die als Dateninhalt vorne ein Symbol für die Tokenart und dahinter optional ein Symbol für einen Offset (32) und/oder maximal 32 Extrabit (34) enthalten, wobei bevorzugterweise die Anzahl der Extrabit (34) durch die Tokenart festgelegt ist.

9. Verfahren nach einem der vorhergehenden Ansprüche,
**dadurch gekennzeichnet,**
**dass** zur Entkomprimierung eine Tokenkategorie der zeichengetreuen Wiedergabe mit Token (28) verwendet wird, die eine Zeichenfolge aus vorangestellten oder nachgestellten Nullen oder Einsen separat zum zeichengetreu wiedergegebenen Teil komprimiert.

10. Verfahren nach einem der vorhergehenden Ansprüche,
**dadurch gekennzeichnet,**
**dass** zur Entkomprimierung eine Tokenkategorie von Einwortwiederholungen verwendet wird, deren Token (28) jeweils auf ein früheres Wort (30) verweisen und Änderungen von einem oder zwei hintereinander liegenden Bits zulassen.

11. Verfahren nach einem der vorhergehenden Ansprüche,
**dadurch gekennzeichnet,**
**dass** zur Entkomprimierung eine Tokenkategorie von Mehrwortwiederholungen verwendet wird, deren Token (28) jeweils mehrere unmittelbar hintereinander liegende identische Wörter (30) bezeichnen.

12. Verfahren nach einem der vorhergehenden Ansprüche,
**dadurch gekennzeichnet,**
**dass** zur Entkomprimierung eine Tokenkategorie von Ketten gleicher Wörter verwendet wird, deren Token (28) jeweils auf eine Reihe von unmittelbar vorab liegenden identischen Wörtern (30) verweisen.

13. Verfahren nach einem der vorhergehenden Ansprüche,
**dadurch gekennzeichnet,**
**dass** zur Entkomprimierung verschiedener Tokentypen die Reihenfolge der Tokentypen so abgeprüft wird, dass zunächst Tokentypen der zeichengetreuen Tokenkategorie, dann Tokentypen der Tokenkategorie der Einwortwiederholungen und dann weitere Tokentypen der zeichengetreuen Tokenkategorie abgeprüft werden.

14. Verfahren nach einem der vorhergehenden Ansprüche,
**dadurch gekennzeichnet,**
**dass** die Programmdaten (22) einen vollständigen Programmdatensatz bilden, der als ein einziger Datenblock komprimiert ist, in dessen Modellteil sämtliche Dekodierbäume enthalten sind, die zur Entkomprimierung verwendet werden.

15. Verfahren nach einem der vorhergehenden Ansprüche,
**dadurch gekennzeichnet,**
**dass** die komprimierten Programmdaten (22) in zwei ineinander verschachtelten Sequenzen aus jeweils Wörtern gleicher Länge vorliegen, bei dem die erste Wortsequenz aus komprimierten Programmdaten (22) und die zweite Wortsequenz aus unkomprimierten Programmdaten (22) besteht.

16. Verfahren nach einem der vorhergehenden Ansprüche,
**dadurch gekennzeichnet,**
**dass** die komprimierten Programmdaten (22) in mehreren Datenblöcken vorliegen, wobei die Anzahl der Datenblöcke der Anzahl der Rechenkerne der CPU (12) gleicht und sich bevorzugterweise die Anzahl der Token (28) in den Datenblöcken um maximal 20 % voneinander unterscheiden.

17. Flugabwehrsystem (2) mit einem Flugkörper (4) und einem Datenverarbeitungssystem (10) zum Steuern eines Betriebs des Flugkörpers (4), wobei das Datenverarbeitungssystem (10) eine CPU (12), einen flüchtigen Datenspeicher (16) und einen nichtflüchtigen Datenspeicher (14) aufweist und Software enthält, die bei ihrer Ausführung bewirkt, dass komprimierte Programmdaten (22) aus dem nichtflüchtigen Datenspeicher (14) durch die CPU (12) entkomprimiert werden und sie entkomprimiert in den flüchtigen Datenspeicher (16) abgelegt werden, sie von dort zu einem Programmstart aufgerufen und mit ihnen ein Programm ausgeführt wird.

**FIG 1**

**FIG 2**

# FIG 3

# FIG 4

```
  ┌──────────────┐
  │ Token Symbol │ ╮ 38
  └──────┬───────┘
         │
         ▼
    ╱─────────╲  40
   ╱  Zero /   ╲
  ╱  Verbatim   ╲──Yes──▶  ╱─────────╲  48
  ╲   Literal   ╱         ╱Zero Literal╲──No──▶ ┌──────────────────┐
   ╲─────────╱           ╲             ╱        │ Verbatim Literal │
        │                 ╲─────────╱           └──────────────────┘
        │                      │
       No                     Yes
        │                      ▼
        │                ┌──────────────┐
        │                │ Zero Literal │
        │                └──────────────┘
        ▼
    ╱─────────╲  42            ╱─────────╲  50          ╱─────────╲  52          ╱─────────╲  54      ┌──────────────┐
   ╱           ╲             ╱           ╲            ╱           ╲            ╱           ╲          │  ARM Branch  │
  ╱ Short Match ╲──Yes──▶   ╱  Verbatim   ╲──No──▶  ╱  1-Bit Delta ╲──No──▶  ╱  2-Bit Delta ╲──No──▶ │  Short Match │
  ╲             ╱           ╲             ╱          ╲             ╱          ╲             ╱          └──────────────┘
   ╲─────────╱               ╲─────────╱              ╲─────────╱              ╲─────────╱
        │                        │                        │                        │
       No                       Yes                      Yes                      Yes
        │                        ▼                        ▼                        ▼
        │                ┌──────────────┐        ┌──────────────┐        ┌──────────────┐
        │                │   Verbatim   │        │  1-Bit Delta │        │  2-Bit Delta │
        │                │  Short Match │        │  Short Match │        │  Short Match │
        │                └──────────────┘        └──────────────┘        └──────────────┘
        ▼
    ╱─────────╲  44            ╱─────────╲  56          ╱─────────╲  58          ╱─────────╲  60      ┌────────────────┐
   ╱  Short /  ╲             ╱           ╲            ╱           ╲            ╱           ╲          │ Sparse Negative│
  ╱  Sparse     ╲──Yes──▶   ╱   Short     ╲──No──▶  ╱   Sparse     ╲──No──▶  ╱Short Negative╲──No──▶ │    Literal     │
  ╲   Literal   ╱           ╲             ╱          ╲             ╱          ╲             ╱          └────────────────┘
   ╲─────────╱               ╲─────────╱              ╲─────────╱              ╲─────────╱
        │                        │                        │                        │
       No                       Yes                      Yes                      Yes
        │                        ▼                        ▼                        ▼
        │                ┌──────────────┐        ┌──────────────┐        ┌──────────────┐
        │                │    Short     │        │    Sparse    │        │Short Negative│
        │                │   Literal    │        │   Literal    │        │   Literal    │
        │                └──────────────┘        └──────────────┘        └──────────────┘
        ▼
    ╱─────────╲  46
   ╱           ╲         ┌──────────────┐
  ╱     Run     ╲──Yes──▶│     Run      │
  ╲             ╱        └──────────────┘
   ╲─────────╱
        │
       No
        ▼
  ┌──────────────┐
  │  Long Match  │
  └──────────────┘
```

Europäisches
Patentamt

European
Patent Office

Office européen
des brevets

**EUROPÄISCHER RECHERCHENBERICHT**

Nummer der Anmeldung

EP 19 18 9983

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | EP 1 389 757 A2 (EADS ASTRIUM GMBH [DE]) 18. Februar 2004 (2004-02-18) * Zusammenfassung * * Absatz [0001] - Absatz [0013] * * Absatz [0018] - Absatz [0029] * * Ansprüche 1-11; Abbildungen 1-2 * ----- | 1-17 | INV. G06F9/4401 G06F9/445 H03M7/30 |

RECHERCHIERTE
SACHGEBIETE (IPC)

G06F
H03M

Der vorliegende Recherchenbericht wurde für alle Patentansprüche erstellt

| Recherchenort | Abschlußdatum der Recherche | Prüfer |
|---|---|---|
| München | 18. Dezember 2019 | Skomorowski, Markus |

KATEGORIE DER GENANNTEN DOKUMENTE

X : von besonderer Bedeutung allein betrachtet
Y : von besonderer Bedeutung in Verbindung mit einer
   anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder
   nach dem Anmeldedatum veröffentlicht worden ist
D : in der Anmeldung angeführtes Dokument
L : aus anderen Gründen angeführtes Dokument

   ...................................................................................
& : Mitglied der gleichen Patentfamilie, übereinstimmendes
   Dokument

EPO FORM 1503 03.82 (P04C03)

## ANHANG ZUM EUROPÄISCHEN RECHERCHENBERICHT
## ÜBER DIE EUROPÄISCHE PATENTANMELDUNG NR.

EP 19 18 9983

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

18-12-2019

| Im Recherchenbericht angeführtes Patentdokument | Datum der Veröffentlichung | Mitglied(er) der Patentfamilie | Datum der Veröffentlichung |
|---|---|---|---|
| EP 1389757 A2 | 18-02-2004 | DE 10236571 A1<br>EP 1389757 A2<br>US 2004030824 A1 | 26-02-2004<br>18-02-2004<br>12-02-2004 |

EPO FORM P0461

Für nähere Einzelheiten zu diesem Anhang : siehe Amtsblatt des Europäischen Patentamts, Nr.12/82